# FASCICULE DE BREVET EUROPEEN

(11) **EP 2 509 076 B1**
(45) Date de publication et mention de la délivrance du brevet: **26.06.2019**
(21) Numéro de dépôt: 12161686.6
(22) Date de dépôt: 28.03.2012
(51) Int. Cl.: G11C 13/00, G11C 11/34, G11C 13/02

(54) **Dispositif électronique de type sélecteur**
Elektronische Vorrichtung vom Typ Wählschalter
Electronic device such as a selector

(30) Priorité: 04.04.2011 FR 1152887
(43) Date de publication de la demande: 10.10.2012
(73) Titulaire: Commissariat à l'Énergie Atomique et aux Énergies Alternatives, 75015 Paris (FR)
(72) Inventeur: Nodin, Jean-François, 38120 Saint-Egreve (FR)
(74) Mandataire: Lebkiri, Alexandre

(56) Documents cités:
- WO-A1-2010/136056
- US-A1- 2005 286 211
- US-A1- 2007 148 882
- US-A1- 2008 023 798
- US-A1- 2010 110 765
- US-A1- 2011 084 248

## Description

La présente invention concerne un dispositif électronique à conduction ionique de type sélecteur ; l'invention trouve une application particulièrement intéressante dans le cas d'une utilisation avec des mémoires non volatiles réinscriptibles résistives basées sur des matériaux actifs.

En fonction des applications et des performances visées, différents types de mémoires sont utilisées.

Ainsi, les mémoires de type SRAM, ou mémoires vives statiques, offrent des temps d'écriture ultra-rapides, requis par exemple lors de calculs par un micro-processeur. L'inconvénient majeur de ces mémoires est qu'elles sont volatiles et que la taille du point mémoire relativement grande ne permet pas d'obtenir une grande capacité de stockage dans un volume raisonnable.

Les mémoires de type DRAM, ou mémoires vives dynamiques, réalisant le stockage de charges électriques dans des capacités, offrent une grande capacité de stockage. Ces mémoires possèdent toutefois des temps d'écriture plus élevés (quelques dizaines de nanosecondes) que ceux des mémoires de type SRAM et sont elles aussi volatiles, le temps de rétention de l'information étant de l'ordre de quelques dizaines de millisecondes.

Pour des applications qui nécessitent un stockage de l'information même lorsque la tension est coupée, des mémoires non volatiles de type EEPROM ou FLASH qui réalisent un stockage de charges sur des grilles flottantes de transistors à effet de champ, sont utilisées. Ces mémoires présentent toutefois des inconvénients :
- temps d'écriture longs (quelques microsecondes),
- densité limitée car la réduction de la taille des transistors conduit à une diminution du signal de lecture, c'est-à-dire une baisse de la différence entre les deux états du point mémoire, et une réduction de la durée de rétention de l'information,
- nombre de cycles d'écriture limité car la capacité de rétention de l'information diminue au fur et à mesure des cycles d'écriture à cause de la création de défauts dans l'oxyde de grille des transistors, permettant aux électrons de s'échapper de la grille flottante.

Plus récemment, d'autres types de mémoires non volatiles réinscriptibles sont apparus, basés sur des matériaux actifs tels que des matériaux à conduction ionique (mémoires CBRAM ou « Conductive Bridging RAM »), à oxydes métalliques (mémoires OxRAM ou « Oxide Resistive RAM »), ferroélectriques (mémoires FERAM ou « Ferroelectric RAM »), magnétiques (mémoires MRAM ou « Magnetic RAM), magnétiques à transfert de spin (mémoires STTRAM ou « Spin Torque Transfer RAM ») ou encore à changement de phase (mémoires PCRAM ou « Phase Change RAM »). Ces mémoires sont des mémoires de type résistive (i.e. elles peuvent présenter au moins deux états « OFF » ou « ON » correspondant au passage d'un état résistif (état « OFF ») à un état moins résistif (état « ON »)).

Le document US2005/0286211 décrit un dispositif électronique de type cellule pour FPGA comportant une électrode inerte, une électrode réactive, un électrolyte solide à base d'un matériau conducteur ionique et présentant deux états résistifs haut et bas. Le document US2010/110765 décrit un dispositif de type CBRAM bipolaire en série avec un commutateur à changement de phase unipolaire.

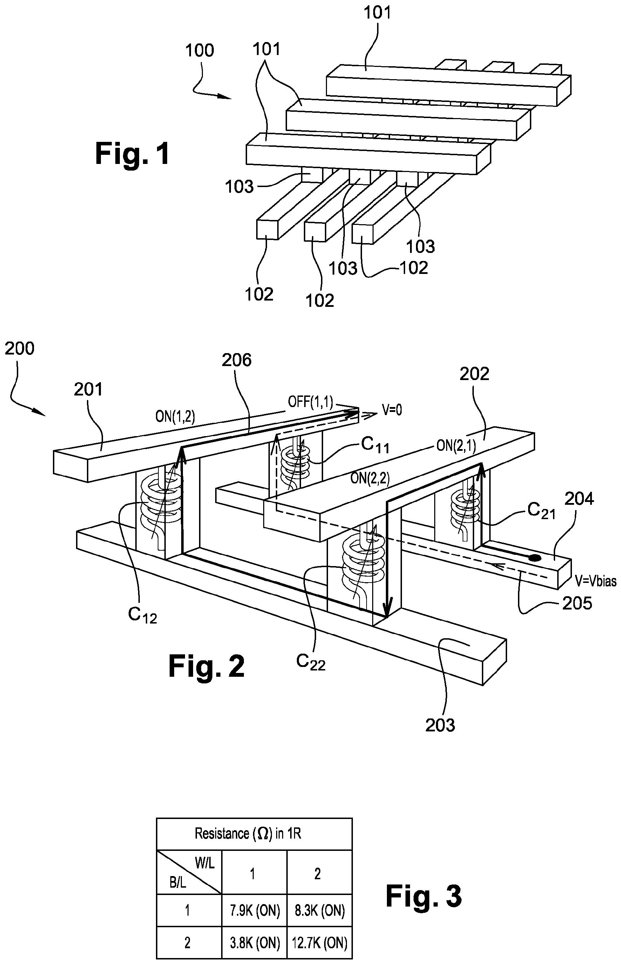

Les mémoires résistives présentent notamment l'intérêt de pouvoir s'intégrer avec de fortes densités, via une intégration de type « cross-bar » (désignée également par la terminologie « cross-point ») :
Une telle architecture 100 est illustrée sur la figure 1 et comporte une pluralité de lignes d'accès 101 et 102 et une pluralité de cellules mémoires 103 de type non volatiles réinscriptibles basées sur des matériaux actifs (par exemple des cellules CBRAM). Les lignes d'accès sont formées par des lignes de bits 101 parallèles supérieures et des lignes de mots 102 inférieures perpendiculaires aux lignes de bits, les cellules élémentaires 103 étant prises en sandwich à l'intersection entre les lignes de bits 101 et les lignes de mots 102. L'architecture 100 forme ainsi un réseau où chaque cellule mémoire 103 est adressable individuellement, en sélectionnant la bonne ligne de bits et la bonne ligne de mots.

Ce type d'architecture présente toutefois certains inconvénients.

Ainsi, la phase de lecture de l'état d'une cellule est réalisée par la polarisation de la ligne et de la colonne souhaitées ; il est alors possible d'observer un courant de fuite parasite passant par les cellules adjacentes. Ce phénomène est illustré sur la figure 2.

La figure 2 représente une architecture d'adressage 200 d'une pluralité de cellules mémoires (ici quatre cellules C11, C21, C22 et C12) de type non volatiles réinscriptibles basées sur des matériaux actifs (par exemple des cellules CBRAM). Cette matrice 200 comporte deux lignes de bits 201 et 202 et deux lignes de mots 203 et 204 permettant notamment de lire l'état résistif de chacune des cellules C11, C21, C22 et C12. En l'espèce, nous faisons ici l'hypothèse que :
- La cellule C11 est à l'état OFF (état haute résistance) ;
- La cellule C21 est à l'état ON (état basse résistance) ;
- La cellule C22 est à l'état ON (état basse résistance) ;
- La cellule C12 est à l'état ON (état basse résistance).

La lecture de l'état résistif de la cellule C11 implique de polariser respectivement la ligne de bits 201 et la ligne de mots 204 (application d'une différence de potentiel Vbias entre ces deux lignes).

En théorie, le courant de mesure devrait circuler uniquement selon la flèche 205 représentée en pointillés.

En pratique, du fait que les trois autres cellules sont à l'état ON, un courant de fuite parasite, représenté par la flèche 206, passe par les cellules non résistives C21, C22 et C12. Ce courant de fuite, en particulier dans le cas défavorable où les éléments adjacents de la cellule à mesurer sont à l'état ON, peut perturber la mesure jusqu'à empêcher la discrimination entre l'état ON et l'état OFF de la cellule à mesurer. Ainsi, la figure 3 représente un tableau indiquant les valeurs des résistances des différentes cellules C11, C21, C22 et C12. On observe dans le cas présent une valeur de résistance de la cellule C11 égale à 7,9 kΩ comparables aux valeurs des résistances des trois autres cellules alors que la cellule est en réalité à l'état OFF et a donc une résistance de l'ordre du MΩ : la mesure est donc totalement faussée.

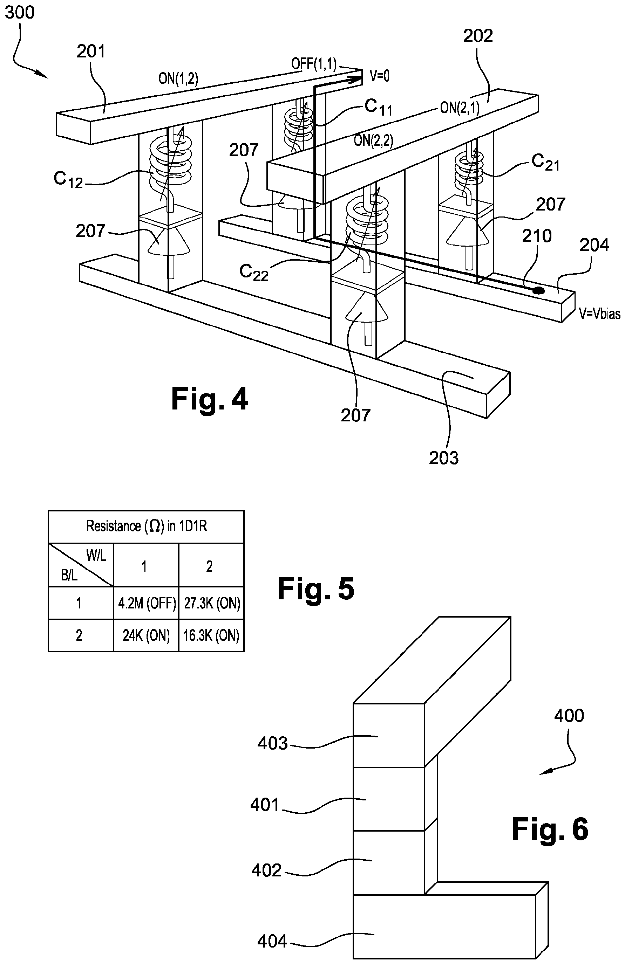

Une solution connue à ce problème consiste à rajouter, en série avec chacune des cellules, une diode à jonction p/n 207. Une telle architecture 300 est illustrée en figure 4. Les éléments communs portent les mêmes numéros de référence sur les figures 2 et 4, étant entendu que les cellules C11, C21, C22 et C12 de la figure 4 sont dans le même état résistif que les cellules C11, C21, C22 et C12 de la figure 2.

Dans ce cas, les diodes 105 étant unipolaires, elles bloquent le passage du courant parasite, autorisant ainsi uniquement le courant représenté par la flèche 210 induit par la polarisation de la ligne de bits 201 et la ligne de mots 204 (application d'une différence de potentiel Vbias entre ces deux lignes).

Ainsi, la figure 5 représente un tableau indiquant les valeurs des résistances des différentes cellules C11, C21, C22 et C12. On observe dans le cas de l'architecture de la figure 4, des valeurs de résistance représentatives de la réalité avec une résistance de la cellule C11 égale à 4,2 MΩ (étant OFF) à comparer aux valeurs des résistances des trois autres cellules de l'ordre d'une dizaine de kΩ : la mesure est donc correcte.

L'architecture telle qu'illustrée en figure 4 pose toutefois également certaines difficultés liées en particulier au fait que les diodes présentent des intensités de courant en mode passant qui restent limitées.

Ainsi, actuellement, pour une surface de silicium donnée, il n'est pas possible de réaliser une diode de même surface que la cellule mémoire et ayant un courant passant Iₒₙ suffisant (densité de courant des diodes trop faible) et dans le même temps un courant de fuite I_{off} assez faible. Une telle situation pose notamment de sérieuses difficultés dans le cas de l'utilisation d'une diode en série avec une cellule de type à changement de phase PCRAM qui nécessite des courants de commutation importants.

Une solution connue à cette difficulté consiste à utiliser des diodes basse température ayant des caractéristiques moyennes assez satisfaisantes en termes de densité de courant (10⁵ à 10⁸ A/cm²). L'utilisation de ces diodes basse température pose toutefois un problème majeur dans des intégrations crossbar multi couches (plusieurs couches de diodes en série avec des cellules mémoires résistives superposées afin de gagner en densité d'intégration ; en d'autres termes, on superpose plusieurs architectures 300 telles que représentées en figure 4). En effet, la fabrication d'une diode basse température nécessite un recuit d'activation à haute température (typiquement 1100°C). De telles températures de recuit ne sont pas compatibles avec les mémoires résistives à base de chalcogénure (PCRAM et CBRAM) qui supportent difficilement des températures de fabrication supérieures à 450°C.

Une alternative à l'utilisation de diode en série avec la cellule mémoire consiste à utiliser une architecture 400 (cf. figure 6) comportant une cellule à électrolyte 401 en série avec une cellule mémoire résistive 402, les deux cellules se trouvant entre une ligne de bits 403 et une ligne de mots 404 ; un exemple d'une telle configuration est décrit dans le document US7382647. L'avantage d'une telle solution est qu'elle autorise des densités de courant assez élevées en mode passant.

Le fonctionnement de la cellule à électrolyte 401 est proche de celui d'un dispositif de type CBRAM et est basé sur la formation, au sein de l'électrolyte solide, d'éléments métalliques appelés « dendrites » entre deux électrodes, lorsque ces électrodes sont portées à des potentiels respectifs appropriés. La formation des dendrites permet d'obtenir une conduction électrique donnée entre les deux électrodes. En modifiant les potentiels respectifs appliqués aux électrodes, il est possible de modifier la répartition et le nombre des dendrites, et de modifier ainsi la conduction électrique entre les deux électrodes. En inversant par exemple le potentiel entre les électrodes, il est possible de faire disparaître ou de réduire les dendrites, de manière à supprimer ou à réduire considérablement la conduction électrique due à la présence des dendrites. Les dispositifs à électrolyte solide peuvent ainsi avoir un fonctionnement à deux états : un état dit « ON » et un état dit « OFF » et jouer par exemple le rôle de sélecteur.

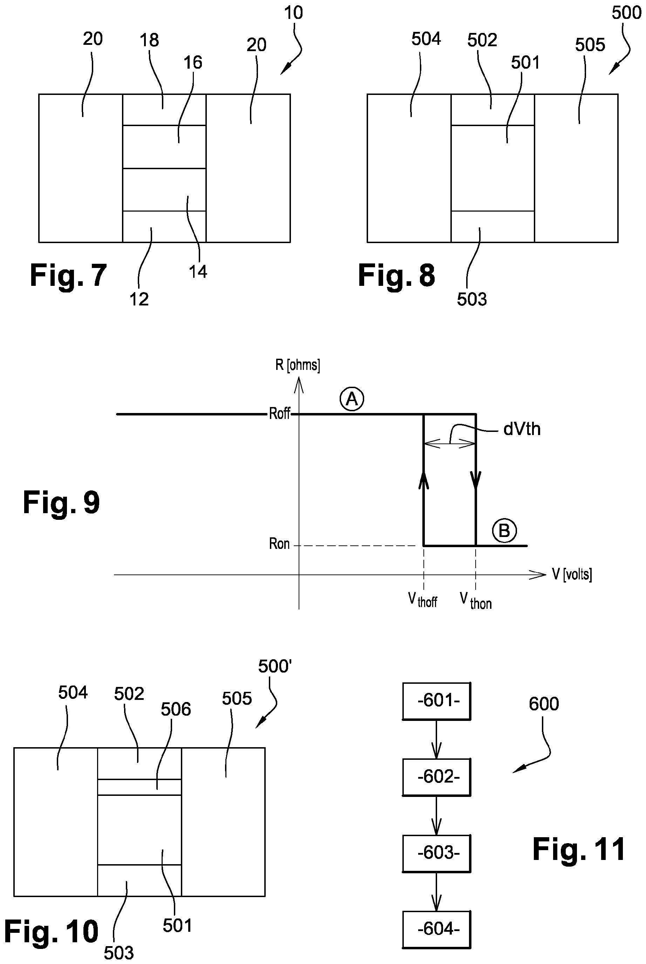

A titre illustratif, la figure 7 représente un schéma de principe d'un dispositif électronique 10 de type CBRAM. Ce dispositif 10 comporte un électrolyte solide 14, par exemple à base de chalcogénure dopé tel que du GeSe, disposé entre une électrode inférieure 12 de nickel, formant une cathode inerte, et une portion de métal ionisable 16 à base d'argent, c'est-à-dire une portion de métal pouvant facilement former des ions métalliques (ici des ions argent Ag⁺), et formant une anode. Une électrode supérieure 18 est disposée sur la portion de métal ionisable 16. Ces éléments sont isolés électriquement par des portions diélectriques latérales 20 à base de SiO₂ ou de SiN, disposées autour de ces éléments.

L'état d'un dispositif mémoire CBRAM résulte de la différence de résistivité électrique entre deux états : ON et OFF. A l'état OFF, les ions métalliques (ici des ions Ag+) issus de la portion de métal ionisable 16 sont dispersés dans tout l'électrolyte solide 14. Ainsi, aucun contact électrique n'est établi entre l'anode et la cathode, c'est-à-dire entre la portion de métal ionisable 16 et l'électrode inférieure 12. L'électrolyte solide 14 forme une zone électriquement isolante de grande résistivité entre l'anode 16 et la cathode 12. Une opération d'écriture dans le dispositif mémoire 10 est réalisée en appliquant une différence de potentiel entre l'anode 16 et la cathode 12. Les ions métalliques Ag+ initialement dispersés dans l'électrolyte solide 14 migrent alors vers la cathode 12 pour former un dépôt métallique. Ce dépôt métallique prend la forme de nanofils métalliques, appelés « dendrites », croissant progressivement au sein du milieu électrolytique sous l'effet de la tension appliquée et finissant par établir des ponts de conduction électrique entre l'anode 16 et la cathode 12 : c'est l'état ON. L'électrolyte solide 14 forme alors une zone électriquement conductrice grâce aux nanofils métalliques formés entre l'anode 16 et la cathode 12. Une opération d'effacement est réalisée en appliquant une différence de potentiel de signe opposé, entre les électrodes 12 et 18, le dépôt métallique (les nanofils) précédemment formé se « dissolvant » sous forme ionique dans l'électrolyte solide 14, permettant au dispositif 10 de revenir à l'état OFF.

L'utilisation d'un dispositif de type à électrolyte solide en tant que sélecteur en série avec la cellule mémoire (à la place d'une diode p/n) pose également certaines difficultés. Ce mode de fonctionnement nécessite en effet une commutation commandée du dispositif sélecteur indépendante de l'écriture/lecture de la cellule mémoire. Dès lors, le pilotage de cet ensemble est assez complexe à réaliser. Il nécessite entre autre la commutation du sélecteur pour permettre l'accès ou l'isolement de la mémoire résistive.

Dans ce contexte, la présente invention vise à fournir un dispositif électronique permettant d'être utilisé en tant que sélecteur en série avec une cellule élémentaire de type mémoire résistive, présentant un courant en mode passant suffisant pour une utilisation avec les cellules résistives basées sur des matériaux actifs, notamment les cellules de type PCRAM, compatible avec une intégration « cross-bar » multicouche et ne nécessitant pas un pilotage indépendant pour permettre l'accès ou l'isolement de la cellule mémoire résistive.

A cette fin, l'invention propose un dispositif électronique comportant :
- une première électrode ;
- une deuxième électrode ;
- un électrolyte solide à base d'un matériau conducteur ionique, lesdites première et deuxième électrodes étant respectivement disposées de part et d'autre dudit électrolyte, lesdites première et deuxième électrodes étant configurées pour former au moins une dendrite métallique entre ladite première électrode et ladite deuxième électrode à partir des ions métalliques circulant dans ledit électrolyte lorsqu'une différence de potentiel supérieure ou égale à une première tension seuil positive est appliquée entre ladite première électrode et ladite deuxième électrode ;
ledit dispositif présentant deux états résistifs :
- un état de haute résistance, dit état résistif haut ;
- un état de basse résistance, dit état résistif bas ;
ledit dispositif étant caractérisé en ce que la concentration du métal formant les ions métalliques dans ledit électrolyte est choisie de sorte que :
- ledit dispositif reste à l'état résistif haut tant que ladite première tension seuil entre ladite première électrode et ladite deuxième électrode n'est pas atteinte ;
- ledit dispositif bascule de l'état résistif haut à l'état résistif bas lorsque la différence de potentiel entre ladite première électrode et ladite deuxième électrode est supérieure ou égale à ladite première tension seuil ;
- ledit dispositif bascule de l'état résistif bas à l'état résistif haut lorsque la différence de potentiel entre ladite première électrode et ladite deuxième électrode supérieure ou égale à ladite première tension seuil n'est plus appliquée et atteint en décroissant une deuxième tension seuil positive strictement inférieure à ladite première tension seuil.

On entend par dendrite au moins un nanofil métallique formé par la croissance d'ions métalliques au sein de l'électrolyte.

De façon particulièrement surprenante, le demandeur s'est aperçu que le comportement résistif d'un électrolyte solide à base d'un matériau conducteur ionique pouvait être sensiblement modifié par rapport au comportement classique des cellules CBRAM connues de l'état de la technique en utilisant une concentration appropriée du métal formant les ions métalliques dans ledit électrolyte.

Le dispositif selon l'invention possède deux états résistifs : un premier état OFF fortement résistif en polarité négative ainsi qu'en polarité positive si la différence de potentiel entre la première électrode et la deuxième électrode est inférieure à une première tension seuil positive Vthon (correspondant par exemple une résistance Roff supérieure à 10⁸ Ω).

Pour une tension supérieure ou égale à Vthon, le dispositif selon l'invention commute vers un état ON basse résistance (par exemple une résistant Ron comprise entre 10 Ω et 1kΩ).

Lorsqu'on cesse d'appliquer une tension supérieure ou égale à Vthon, la différence de potentiel entre la première et la deuxième électrode diminue spontanément à partir de Vthon (ou à partir d'une tension supérieure à Vthon) ; dès que la différence de potentiel entre la première et la deuxième électrode atteint une seconde tension seuil Vthoff positive, le dispositif selon l'invention commute du second état ON bassement résistif vers le premier état OFF hautement résistif. Le retour de l'état basse impédance à l'état haute impédance se fait automatiquement lorsque la tension revient en dessous de la tension seuil positive Vthoff. Ce comportement du dispositif selon l'invention est fondamentalement différent du comportement d'une cellule CBRAM standard présentant un effet mémoire, qui nécessite l'application d'une tension négative pour revenir à l'état OFF haute impédance. Selon l'invention, lorsque la différence de potentiel entre la première électrode et la deuxième électrode décroit naturellement de la première tension positive seuil Vthon à la deuxième tension positive Vthoff, le basculement de l'état ON à l'état OFF se fait automatiquement sans nécessité de commander le dispositif par une différence de potentiel négative entre la première et la deuxième électrode.

Tout comme un dispositif CBRAM standard, le dispositif de la présente invention fonctionne également avec un électrolyte solide, mais dans un régime différent grâce au contrôle précis de la quantité d'ions solubles présent dans l'électrolyte. A ce titre, il est intéressant de constater que, contrairement aux cellules CBRAM classiques, le fonctionnement du dispositif selon l'invention n'est pas particulièrement adapté à un fonctionnement en tant que cellule mémoire non volatile réinscriptible dans la mesure où le basculement de l'état ON vers l'état OFF se fait automatiquement sans commande de la différence de potentiel entre les électrodes.

En revanche, le dispositif selon l'invention peut être avantageusement utilisé en tant que sélecteur en série avec une cellule mémoire de type résistive, les deux éléments en série étant disposés entre deux lignes d'accès (ligne de bits et ligne de mots). Contrairement, à une cellule mémoire résistive en série avec un dispositif CBRAM standard utilisé en tant que sélecteur, un tel agencement ne nécessite pas le pilotage indépendant du sélecteur, simplifiant ainsi l'électronique de pilotage.

Le dispositif selon l'invention peut en outre être élaboré à basse température (typiquement une température inférieure à 250°C) et est donc pleinement compatible avec une intégration « cross-bar » multi couches avec des matériaux de type chalcogénure sensibles à des températures trop élevées.

Le dispositif selon l'invention peut également présenter une ou plusieurs des caractéristiques ci-dessous, considérées individuellement ou selon toutes les combinaisons techniquement possibles :
- la concentration de métal formant les ions métalliques dans l'électrolyte est inférieure à la concentration de saturation dudit métal dans le matériau formant l'électrolyte ;
- le dispositif selon l'invention comporte une portion de métal ionisable intercalée entre ladite première électrode et ledit électrolyte ;
- lesdits ions métalliques circulant dans ledit électrolyte sont des ions Ag²⁺, Zn²⁺ ou Cu²⁺ ;
- ledit électrolyte solide est réalisé à partir d'un matériau chalcogénure tel qu'un séléniure ou un tellurure, de certains oxydes tels que SiO₂, HfO₂, Ta₂O₅, TiO₂, GdOx, CuOx, WOx, ou de sulfures tels que GeSₓ, CuₓS ou AgS.

La présente invention a également pour objet une cellule élémentaire caractérisée en ce qu'elle comporte un dispositif selon l'invention monté en série avec une cellule mémoire apte à présenter au moins deux états de résistivité correspondant à deux états mémoire.

La cellule élémentaire selon l'invention peut également présenter une ou plusieurs des caractéristiques ci-dessous, considérées individuellement ou selon toutes les combinaisons techniquement possibles :
- ladite cellule mémoire est une cellule mémoire non volatile réinscriptible telle qu'une mémoire OxRAM, CBRAM, MRAM, PCRAM, FeRAM ou STTRAM ;
- la cellule élémentaire comporte deux dispositifs selon l'invention montés tête bêche en parallèle, l'ensemble desdits deux dispositifs en parallèle étant monté en série avec ladite cellule mémoire.

La présente invention a également pour objet une matrice d'adressage d'une pluralité de cellules élémentaires caractérisée en ce qu'elle comporte :
- une pluralité de cellules élémentaires selon l'invention ;
- deux niveaux de lignes de commande :
   ∘ un premier niveau incluant une pluralité de lignes de bits parallèles entre elles ;
   ∘ un deuxième niveau incluant une pluralité de lignes de mots parallèles entre elles ;
chacune desdites cellules étant disposée au croisement d'une ligne de mots et d'une ligne de bits.

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente schématiquement une architecture de type « cross-bar » ;
- la figure 2 représente une première architecture d'adressage d'une pluralité de cellules mémoires selon l'état de la technique ;
- la figure 3 est un tableau indiquant les valeurs des résistances des différentes cellules de l'architecture de la figure 2 ;
- la figure 4 représente une deuxième architecture d'adressage d'une pluralité de cellules mémoires selon l'état de la technique ;
- la figure 5 est un tableau indiquant les valeurs des résistances des différentes cellules de l'architecture de la figure 4 ;
- la figure 6 représente une troisième architecture d'adressage d'une pluralité de cellules mémoires selon l'état de la technique ;
- la figure 7 représente schématiquement un dispositif à conduction ionique du type CBRAM selon l'état de la technique ;
- la figure 8 représente schématiquement un premier mode de réalisation d'un dispositif selon l'invention ;
- la figure 9 illustre l'évolution de la résistance du dispositif de la figure 8 en fonction de la différence de potentiel appliquée entre les électrodes du dispositif ;
- la figure 10 représente schématiquement un deuxième mode de réalisation d'un dispositif selon l'invention ;
- la figure 11 illustre les étapes principales du procédé de fabrication d'un dispositif selon l'invention tel que le dispositif des figures 8 ou 10;
- la figure 12 illustre la méthode itérative permettant de déterminer le ratio entre l'épaisseur de l'électrolyte et l'épaisseur de la couche de métal soluble pour l'obtention d'une tension adaptée à un dispositif selon l'invention ;
- la figure 13 illustre l'évolution de la résistance d'une cellule de type CBRAM connue en fonction de la différence de potentiel appliquée entre les électrodes de la cellule ;
- la figure 14 illustre schématiquement une matrice d'adressage intégrant une pluralité de dispositifs selon l'invention ;
- la figure 15 représente schématiquement une cellule élémentaire comportant un dispositif selon l'invention ;
- la figure 16 représente schématiquement une cellule élémentaire comportant deux dispositifs selon l'invention.

Dans toutes les figures, les éléments communs portent les mêmes numéros de référence.

Les figures 1 à 7 ont déjà été décrites en référence à l'état de la technique.

La figure 8 représente schématiquement un dispositif électronique 500 à conduction ionique selon un premier mode de réalisation de l'invention.

Le dispositif électronique 500 comporte :
- un électrolyte solide 501 ;
- une première électrode conductrice 502 ;
- une deuxième électrode conductrice 503 ;
- une première et une deuxième zone isolante électriquement 504 et 505.

L'électrolyte solide 501 peut être réalisé à partir d'un matériau chalcogénure tel qu'un séléniure (GeSe) ou un tellurure, de certains oxydes tels que SiO₂, HfO₂, Ta₂O₅, TiO₂, GdOx, CuOx, WOx, ou de sulfures tels que GeSₓ, CuₓS ou AgS.

L'électrolyte solide est disposé entre la première électrode 502 (électrode supérieure en contact avec la surface supérieure de l'électrolyte) et la deuxième électrode 503 (électrode inférieure en contact avec la surface inférieure de l'électrolyte).

La première électrode (électrode supérieure) 502 est par exemple réalisée dans un matériau en métal inerte tel que Ni ou W et forme une anode.

La deuxième électrode (électrode inférieure) 503 est par exemple réalisée dans un matériau en métal inerte tel que Ni ou W et forme une cathode.

L'empilement formé par la première électrode 502, l'électrolyte 501 et la deuxième électrode 503 est isolé électriquement par des portions diélectriques latérales 504 et 505, par exemple à base de SiO₂ ou de SiN, disposées autour de l'empilement.

Des ions métalliques (par exemple des ions Ag²⁺, Zn²⁺ ou Cu²⁺) sont diffusés dans l'électrolyte solide 501. Cette diffusion dans l'électrolyte solide 501 peut par exemple être obtenue lors de la fabrication du dispositif 500 en utilisant une portion (désignée indifféremment par la suite par la terminologie « électrode soluble ») de métal soluble ionisable (par exemple en Ag, Zn ou Cu) au-dessus de l'électrolyte 501. Lors du dépôt de cette portion de métal ionisable, les ions métalliques issus de cette portion sont dispersés dans l'électrolyte solide 501. Cette diffusion peut être spontanée (il y a diffusion spontanée si le métal diffuse spontanément dans l'électrolyte lors du dépôt sans traitement particulier) ou non spontanée (dans ce cas, la diffusion est stimulée par un traitement tel qu'un traitement thermique ou une stimulation UV). A titre d'exemple, le document "Local structure resulting from photo and thermal diffusion of Ag in Ge-Se thin films" (M. Mitkova *, M.N. Kozicki, H.C. Kim, T.L. Alford, Center for Solid State Electronics Research, Arizona State University, USA) décrit l'obtention d'un film de 35nm de Ge₂₀Se₈₀ déposé par évaporation thermique, 20nm d'argent étant ensuite évaporé sur le GeSe : dans ce cas, la diffusion de l'Ag est ici non spontanée et peut être réalisée soit via une diffusion thermique soit via une diffusion optique. La diffusion thermique est réalisée en soumettant l'échantillon à une température de 200°C. La diffusion optique est réalisée en exposant l'échantillon à une illumination de puissance 6.5mW/cm², pour une longueur d'onde de 436nm.

Inversement, il est possible de réaliser une diffusion spontanée en déposant par pulvérisation cathodique magnétron à faible puissance un film d'Ag sur un film de GeSe : en choisissant les conditions opératoires ad hoc, l'Ag diffuse spontanément de façon homogène dans tout le volume de GeSe.

Une fois obtenue la concentration visée en métal formant les ions métalliques, on procède au dépôt de l'électrode supérieure 502 formant anode.

Selon l'invention, la concentration en métal formant les ions métalliques dans l'électrolyte est choisie pour obtenir la caractéristique résistance-tension telle qu'illustrée en figure 9 qui représente l'évolution de la résistance R (en ohms) du dispositif 500 en fonction de la différence de potentiel V (en volts) entre la première électrode 502 et la deuxième électrode 503.

On observe que le dispositif 500 possède deux états résistifs :
- un état stable (A) haute impédance (avec une résistance Roff > 10⁸ ohms)
- un état (B) basse impédance (avec une résistance 10 ohms < Ron < 10³ ohms) qui se déclenche quand la tension dépasse une première tension de seuil positive Vthon.

Pour une différence de potentiel V supérieure à la première tension seuil Vthon, le dispositif 500 commute vers l'état basse résistance B. En d'autres termes, lorsqu'on applique une différence de potentiel entre la première et la deuxième électrode positive supérieure ou égale à Vthon, on passe de l'état haute résistance A à l'état basse résistance B. Les ions métalliques Ag²⁺ ou Cu²⁺ initialement dispersés dans l'électrolyte solide 501 migrent vers la deuxième électrode 503 pour former un dépôt métallique. Ce dépôt métallique prend la forme de nanofils métalliques, appelés « dendrites», croissant progressivement au sein du milieu électrolytique sous l'effet de la tension Vthon appliquée et finissant par établir des ponts de conduction électrique entre la première et la deuxième électrode 502 et 501.

Lorsqu'on cesse d'appliquer une différence de potentiel entre la première et la deuxième électrode positive supérieure ou égale à Vthon, la tension V entre la première et la deuxième électrode diminue spontanément et atteint une deuxième tension seuil positive Vthoff ; une fois cette deuxième tension seuil positive Vthoff atteinte, le dispositif 500 commute à nouveau de l'état B bassement résistif (étant ON) vers l'état A hautement résistif (état OFF).

Le retour de l'état basse impédance à l'état haute impédance se fait automatiquement lorsque la différence de potentiel entre la première et la deuxième électrode 502 et 503 revient à une tension inférieure ou égale à la deuxième tension seuil Vthoff ; on notera que ce comportement est contraire à celui d'une cellule CBRAM classique présentant un effet mémoire, qui nécessite l'application d'une tension négative pour revenir à l'état OFF haute impédance. On notera également que le dispositif 500 reste dans l'état haute impédance en polarité négative (i.e. avec une différence de potentiel négative entre la première et la deuxième électrode).

L'hystérésis entre la première tension seuil Vthon positive et la deuxième tension seuil positive est notée dVth.

Le type de caractéristique illustrée en figure 9 est préférentiellement observée lorsque la concentration de métal actif formant les ions métalliques dans l'électrolyte est inférieure à la concentration de saturation. Le fait de se placer en-dessous de la saturation permet d'obtenir une deuxième tension seuil Vthoff de retour à l'état OFF positive. On entend par point de saturation le point où on ne peut plus diffuser de métal actif dans l'électrolyte, le métal formant alors des agrégats en surface de l'électrolyte. Le fait d'être sous la saturation permet d'obtenir un comportement différent de celui d'une cellule CBRAM classique nécessitant une tension négative pour revenir à l'état OFF haute impédance : selon l'invention, la fin de l'application de la tension Vthon va entraîner spontanément une cassure de la ou des dendrites avec une re-dissolution des ions au sein de l'électrolyte lorsque la différence de potentiel va atteindre Vthoff sans avoir besoin d'appliquer une tension négative.

Le fait de se placer en-dessous de la saturation entraîne de facto que, dans le cas d'une diffusion spontanée, la portion de métal soluble utilisée pour la réalisation des ions dans l'électrolyte doit complètement disparaître. De même, dans le cas où le matériau de l'électrode supérieure 502 et/ou inférieure 503 est soluble spontanément dans l'électrolyte soluble 501 (typiquement le cas d'une électrode en Cu ou en Ag), une barrière de diffusion devra être déposée (respectivement entre la première électrode 502 et l'électrolyte 501 et/ou entre l'électrolyte 501 et la deuxième électrode 503).

Dans le cas d'une diffusion stimulée, la situation peut être différente et il possible d'adapter la durée et les conditions de stimulation de façon à conserver une partie de la portion de métal soluble entre la première électrode 502 et l'électrolyte 503 tout en ayant une concentration de métal dans l'électrolyte en-dessous de la saturation. Un tel dispositif 500' est illustrée en figure 10 ; le dispositif 500' est identique au dispositif 500 à la différence qu'il comporte une couche 506 de métal soluble (typiquement de l'Ag ou du Cu) dans l'électrolyte mais dont la dissolution a été stoppée avant d'atteindre la saturation. Les autres caractéristiques communes aux dispositifs 500 et 500' portent les mêmes références. La couche 506 est disposée entre l'électrode supérieure 502 et l'électrolyte 501.

Une structure telle que celle du dispositif 500 est également possible dans le cas d'une diffusion stimulée en adaptant la durée et les conditions de stimulation de façon à ce que l'ensemble de la couche de métal soluble soit diffusée dans l'électrolyte 501 tout en restant au-dessous de la saturation.

Quel que soit le mode de réalisation (figure 8 ou figure 10), la figure 11 illustre les étapes principales du procédé de fabrication 600 d'un dispositif selon l'invention.

La première étape 601 consiste à réaliser la deuxième électrode 503 formant l'électrode inférieure. Cette électrode inférieure 503 (deuxième électrode) est réalisée en matériau conducteur (par exemple W ou Ni) et est déposée à l'aide de procédés connus en microélectronique (pulvérisation, CVD,...). L'épaisseur typique de cette deuxième électrode 503 est comprise entre 100nm à 300nm. La deuxième électrode 503 peut-être gravée pour lui donner les dimensions et la forme voulue. Comme nous le verrons par la suite, dans le cas de l'association du dispositif selon l'invention avec une cellule mémoire de type résistive, la section de la deuxième électrode 503 devra également être compatible avec les contraintes liées à la fabrication de la cellule mémoire (température,...).

Selon l'étape 602, l'électrolyte solide 501 est ensuite déposé. L'épaisseur de l'électrolyte sera calculée, entre autre, en fonction du type d'électrolyte choisi, de la résistance à l'état OFF désirée (la résistance OFF est proportionnelle à l'épaisseur de matériau selon la loi R=σ . e / S, où e est l'épaisseur de matériau, σ est la résistivité du matériau et S la surface), de la géométrie du dispositif (surface S), de la tension de claquage du matériau (le champ électrique de claquage doit être supérieur à la tension de commutation du dispositif). Typiquement, l'épaisseur d'électrolyte sera de l'ordre de 10nm à 100nm.

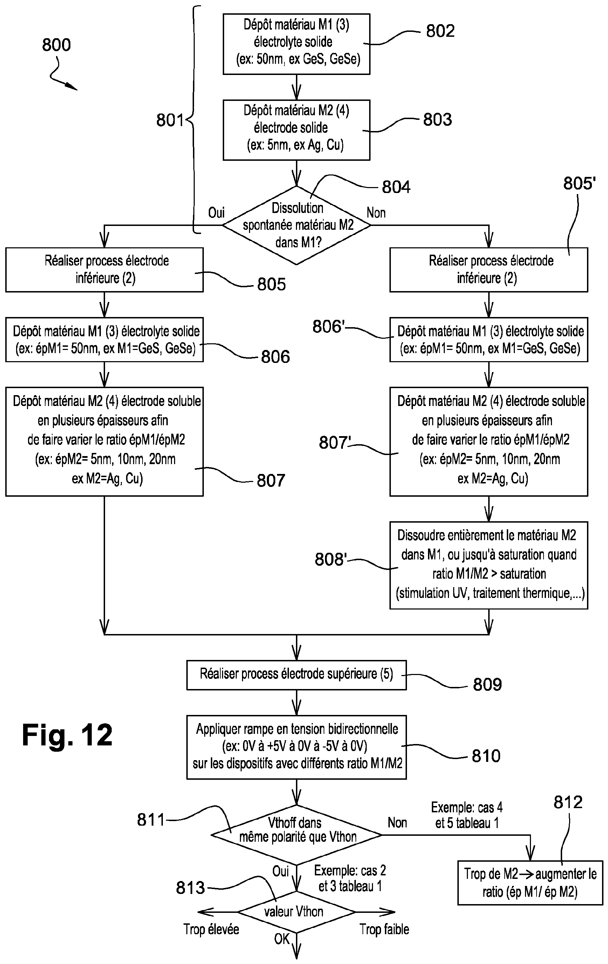

Selon l'étape 603, la portion d'électrode soluble (totalement diffusée dans le cas de la figure 8 et référencée 506 dans le cas de la figure 10), typiquement en Ag ou en Cu, est déposée sur l'électrolyte solide 501. L'épaisseur de l'électrode soluble est déterminée par le matériau de l'électrode, le type de dissolution dans l'électrolyte (diffusion spontanée, diffusion stimulée par UV ou thermiquement), la tension de commutation Vthon souhaitée et l'épaisseur de l'électrolyte solide 501. En tout état de cause, la concentration en élément métallique de l'électrode soluble dans l'électrolyte solide 501 doit être ajustée pour obtenir la tension de commutation Vthon désirée et est inférieure à la saturation pour garantir un retour à l'état OFF spontané. La concentration optimale est déterminée expérimentalement en faisant des variations d'épaisseur déposée de l'électrode soluble 501 dans le cas d'une diffusion spontanée, et/ou en faisant varier les conditions de stimulation dans le cas de diffusion stimulée. Nous reviendrons sur le procédé d'optimisation de la concentration en référence à la figure 12.

L'étape 604 consiste à réaliser la première électrode 502 formant l'électrode supérieure. Cette électrode supérieure 502 est en matériau conducteur (typiquement W ou Ni) et est déposée à l'aide de procédés connus en microélectronique (pulvérisation, CVD,...). L'épaisseur typique de cette première électrode 502 est de l'ordre de 100nm à 300nm. Comme pour la deuxième électrode 503, cette première électrode 502 peut-être gravée pour lui donner les dimensions et la forme voulue.

La surface de la zone active est définie soit par la surface des première et deuxième électrodes 502 et/ou 503 soit par la surface de l'électrolyte solide 501. Cette surface est typiquement de l'ordre de 30nm² à 300nm².

La figure 12 illustre les différentes étapes d'une méthode itérative 800 permettant de déterminer le ratio entre l'épaisseur de l'électrolyte et l'épaisseur de la couche de métal soluble pour l'obtention d'une première tension seuil Vthon.

Cette méthode 800 est une méthode expérimentale permettant de déterminer les épaisseurs ad hoc de l'électrolyte et de la couche de métal soluble afin d'obtenir une caractéristique telle qu'illustrée en figure 9 avec une première et une deuxième tension seuil Vthon et Vthoff données.

La première partie 801 de la méthode 800 va consister à déterminer le type de dissolution, spontanée ou pas, de l'électrode soluble dans l'électrolyte.

Selon une étape 802, on réalise le dépôt d'un électrolyte solide M1 d'épaisseur epM1.

Selon une étape 803, on réalise le dépôt d'une couche d'une électrode métallique soluble M2 d'épaisseur epM2.

Selon une étape 804, on détermine si la dissolution de l'électrode soluble en M2 est spontanée ou pas. Il y a diffusion spontanée de l'électrode soluble M2 si tout ou partie du matériau M2 diffuse dans l'électrolyte solide M1 lors du dépôt de M2. La détermination de la dissolution spontanée ou non se fait par exemple par observation ou mesure de la composition de M1, de la présence de M2 dans M1, mesure de l'épaisseur de M2 (ex: plus de M2 en surface de M1) ou augmentation de l'épaisseur de M1,...

La présence de M2 dans M1 peut être vérifiée par exemple par spectroscopie à rayons X ou par mesure SIMS (« Secondary ion mass spectrometry » en anglais). La mesure des épaisseurs ou la détection d'une diminution d'épaisseur peuvent par exemple être obtenues par spectroscopie à rayons X ou par mesure ellipsométrique.

On réalise ensuite un empilement complet en tenant compte de la diffusion spontanée ou non.

Pour une diffusion spontanée :
- selon l'étape 805, on réalise une électrode inférieure ;
- selon l'étape 806, on dépose le matériau M1 formant l'électrolyte solide avec une épaisseur epM1 ;
- selon l'étape 807, on dépose le matériau M2 de l'électrode soluble en prenant plusieurs épaisseurs epM2 afin de faire varier le ratio epM1/epM2.

Pour une diffusion non spontanée :
- selon l'étape 805', on réalise une électrode inférieure ;
- selon l'étape 806', on dépose le matériau M1 formant l'électrolyte solide avec une épaisseur epM1 ;
- selon l'étape 807', on dépose le matériau M2 de l'électrode soluble en prenant plusieurs épaisseurs epM2 afin de faire varier le ratio epM1/epM2 ;
- selon l'étape 808', on stimule la diffusion.

Selon l'étape 809 commune à la diffusion spontanée ou non, on réalise l'électrode supérieure.

On a ainsi plusieurs échantillons avec une même épaisseur d'électrolyte epM1 et des épaisseurs différentes d'électrodes solubles epM2 (et donc différents ratio epM1/epM2). Des tests électriques sur ces échantillons vont permettre de déterminer le ratio epM1/epM2 ad hoc.

Selon l'étape 810, on applique par exemple une rampe en tension bidirectionnelle entre l'électrode supérieure et l'électrode inférieure (par exemple de 0V à 5V, de 5V à 0V et de 0V à -5V) sur les échantillons présentant des ratios epM1/epM2 différents.

Selon l'étape 811, on mesure l'évolution de la résistance R en fonction de la différence de potentiel V entre l'électrode supérieure et l'électrode inférieure.

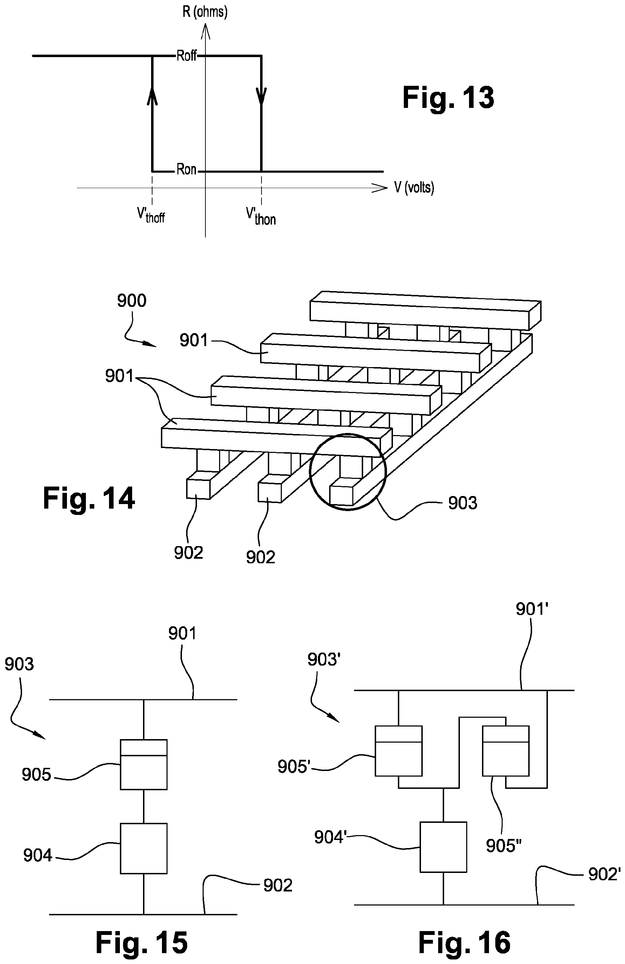

Deux cas de figure sont possibles :
- soit on observe une caractéristique R(V) telle que représentée en figure 13 qui est une caractéristique standard d'une cellule de type CBRAM avec deux états stables nécessitant deux tensions seuils de signes différents (ici Vthoff négative pour passer de l'état ON à l'état OFF et Vthon positive pour passer de l'état OFF à l'état ON) ;
- soit on observe une caractéristique d'un dispositif selon l'invention telle que représentée en figure 9.

On vérifie donc si Vthoff et Vthon sont des tensions positives (étape 811).

Si Vthoff est négative et Vthon est positive, le ratio epM1/epM2 est trop faible et il convient donc d'augmenter ce ratio (étape 812), par exemple en diminuant l'épaisseur epM2. Un ratio epM1/epM2 trop faible correspondant à une tension Vthoff négative et une tension Vthon positive indique que la concentration de métal formant les ions métalliques dans l'électrolyte est à saturation.

Au contraire, si la caractéristique R(V) est conforme à la figure 9 (Vthoff et Vthon positives), la concentration de métal formant les ions métalliques dans l'électrolyte est au-dessous de la saturation et le dispositif fonctionne selon l'invention. Dans ce cas, il est également possible (étape 813) de réduire le ratio epM1/epM2 tout en restant en dessous de la saturation de manière à obtenir une valeur de la première tension seuil Vthon inférieure. Il est également possible d'augmenter encore le ratio epM1/epM2 de manière à obtenir une valeur de la première tension seuil Vthon supérieure. On notera qu'il est également possible d'obtenir une caractéristique R(V) telle que représentée en figure 13 qui est une caractéristique standard d'une cellule de type CBRAM alors qu'on est au-dessous de la saturation ; dans ce cas, il conviendra de baisser encore davantage la concentration en métal formant les ions métalliques.

L'écart entre les première et deuxième tensions seuils pourra être ajusté par le matériau de l'électrolyte.

On trouvera ci-dessous trois exemples de réalisation dans le cas d'une diffusion spontanée d'Ag dans du Ge₂₅Se₇₅ déposé par pulvérisation.

Dans le cas d'un ratio epM1/epM2=2.22, on obtient les valeurs suivantes : Vthon=+1.5V et Vthoff=-0.52V. Vthoff étant négative et Vthon étant positive, le ratio epM1/epM2 est trop faible.

Dans le cas d'un ratio epM1/epM2=5.55, on obtient les valeurs suivantes : Vthon=+4.24V et Vthoff=+1.53V. La caractéristique R(V) est donc conforme à la figure 9 (Vthoff et Vthon positives). La concentration de métal formant les ions métalliques dans l'électrolyte est au-dessous de la saturation et le dispositif fonctionne selon l'invention.

On peut obtenir une valeur de la première tension seuil Vthon inférieure à +4.24V tout en restant en dessous de la saturation en réduisant le ratio epM1/epM2. Ainsi, dans le cas d'un ratio epM1/epM2=3.70, on obtient les valeurs suivantes : Vthon=+3.03V et Vthoff=+0.61V.

Le ratio epM2/epM1 sera préférentiellement compris entre 0.09 et 0.33 (soit un ratio epM1/epM2 compris entre 3.03 et 11,11) de manière à obtenir un dispositif fonctionnant selon l'invention.

Le dispositif selon l'invention 500 ou 500' tel qu'illustré aux figures 8 ou 10 trouve une application particulièrement intéressante lorsqu'il est mis en série avec une cellule mémoire élémentaire apte à présenter au moins deux états de résistivité correspondant à deux états mémoire et intégré dans une matrice d'adressage de type « cross-bar ».

Une telle matrice d'adressage 900 est représentée en figure 14.

La matrice 900 comporte une pluralité de lignes de bits 901 parallèles supérieures et de lignes de mots 902 inférieures perpendiculaires aux lignes de bits, des cellules élémentaires 903 étant prises en sandwich entre les lignes de bits 901 et les lignes de mots 902. Dans ce cas, chaque cellule élémentaire 903 (cf. figure 15) comporte par exemple une cellule mémoire 904 en série avec un dispositif selon l'invention 905, ledit dispositif selon l'invention 905 faisant office de sélecteur du courant circulant dans la cellule mémoire 904 en fonction de la tension appliquée entre la ligne de bits et la ligne de mots.

A chaque croisement d'une ligne de bits et d'une ligne de mots, on trouve donc une cellule élémentaire 903 prise en sandwich entre les deux lignes. Ainsi, si on souhaite lire ou écrire une valeur binaire dans la cellule mémoire 904, on polarise la ligne de bits et la ligne de mots correspondant de façon à placer le dispositif 905 à l'état ON. Le retour à l'état OFF se fera ensuite spontanément dès que l'opération de lecture ou d'écriture est terminée. Le dispositif 905 selon l'invention fait donc office de sélecteur de la cellule mémoire 904 à lire ou à écrire.

La cellule mémoire 904 est préférentiellement une cellule mémoire non volatile réinscriptible de type résistive telle qu'une mémoire OxRAM, CBRAM, MRAM, PCRAM, FeRAM ou STTRAM. On notera que le dispositif selon l'invention 905 et la cellule mémoire peuvent être inversés tant qu'ils sont en série (i.e. le dispositif 905 peut être avant ou après la cellule mémoire 904).

La figure 16 illustre schématiquement un second mode de réalisation d'une cellule élémentaire 903' susceptible d'être utilisée dans une matrice 900 telle que représentée en figure 14.

La cellule élémentaire 903' permet d'adresser des cellules mémoires 904' nécessitant un fonctionnement bipolaire (un premier sens de courant pour passer de l'état OFF à l'étant ON et un deuxième sens de courant, inverse du premier, pour passer de l'état ON à l'état OFF) : c'est le cas par exemple des cellules mémoires à ponts conducteurs ioniques CBRAM.

La cellule élémentaire 903' comporte deux dispositifs selon l'invention 905' et 905" montés en parallèle et tête bêche, les dispositifs 905' et 905" en parallèle étant monté avec la cellule mémoire 904' entre une ligne de bits 901' et une ligne de mots 902'.

Bien entendu, le dispositif et le procédé selon l'invention ne sont pas limités aux modes de réalisation qui viennent d'être décrits à titre indicatif et nullement limitatif en référence aux figures 1 à 16.

Ainsi, il est entendu que le dispositif selon l'invention comporte au moins une dendrite mais peut également comporter une pluralité de dendrites réparties au sein de l'électrolyte.

En outre, même si l'invention a été plus particulièrement décrite dans le cas du dépôt d'une électrode ou portion de métal soluble qui se dissout dans l'électrolyte, soit spontanément soit de façon stimulée, il est également possible d'obtenir un électrolyte comportant des ions métalliques obtenues par copulvérisation ; typiquement, on commence par déposer uniquement le matériau de l'électrolyte solide sur l'électrode inférieure puis on copulvérise le matériau de l'électrolyte solide et un métal soluble dans le matériau de l'électrolyte solide de façon à obtenir une portion d'électrolyte dont la concentration de métal formant les ions métalliques est inférieure à la concentration de saturation.

Par ailleurs, dans le cas d'une cellule élémentaire comportant une cellule mémoire résistive en série avec un dispositif selon l'invention, la première électrode 502 peut être aussi directement la cellule mémoire résistive dans l'hypothèse où celle-ci ne provoque pas d'interaction avec le dispositif sélecteur selon l'invention.

## Revendications

1. Dispositif électronique (500, 500') comportant :
- une première électrode (502) ;
- une deuxième électrode (503) ;
- un électrolyte solide (501) à base d'un matériau conducteur ionique, lesdites première et deuxième électrodes étant respectivement disposées de part et d'autre dudit électrolyte, lesdites première et deuxième électrodes étant configurées pour former au moins une dendrite métallique entre ladite première électrode et ladite deuxième électrode à partir des ions métalliques circulant dans ledit électrolyte lorsqu'une différence de potentiel supérieure ou égale à une première tension seuil positive (Vthon) est appliquée entre ladite première électrode (502) et ladite deuxième électrode (503) ;
ledit dispositif présentant deux états résistifs :
- un état de haute résistance, dit état résistif haut (OFF) ;
- un état de basse résistance, dit état résistif bas (ON) ;
ledit dispositif (500) étant **caractérisé en ce que** la concentration du métal formant les ions métalliques dans ledit électrolyte est choisie de sorte que :
- ledit dispositif reste à l'état résistif haut tant que ladite première tension seuil (Vthon) entre ladite première électrode (502) et ladite deuxième électrode (503) n'est pas atteinte ;
- ledit dispositif bascule de l'état résistif haut à l'état résistif bas lorsque la différence de potentiel entre ladite première électrode (502) et ladite deuxième électrode (503) est supérieure ou égale à ladite première tension seuil (Vthon) ;
- ledit dispositif bascule de l'état résistif bas à l'état résistif haut lorsque la différence de potentiel entre ladite première électrode (502) et ladite deuxième électrode (503) supérieure ou égale à ladite première tension seuil n'est plus appliquée et atteint en décroissant une deuxième tension seuil positive (Vthoff) strictement inférieure à ladite première tension seuil (Vthon).

2. Dispositif (500, 500') selon la revendication 1 **caractérisé en ce que** la concentration de métal formant les ions métalliques dans l'électrolyte est inférieure à la concentration de saturation dudit métal dans le matériau formant l'électrolyte.

3. Dispositif (500') selon l'une des revendications précédentes **caractérisé en ce qu'**il comporte une portion de métal ionisable (506) intercalée entre ladite première électrode et ledit électrolyte.

4. Dispositif (500, 500') selon l'une des revendications précédentes **caractérisé en ce que** lesdits ions métalliques circulant dans ledit électrolyte sont des ions Ag²⁺, Zn²⁺ ou Cu²⁺.

5. Dispositif (500, 500') selon l'une des revendications précédentes **caractérisé en ce que** ledit électrolyte solide (501) est réalisé à partir d'un matériau chalcogénure tel qu'un séléniure ou un tellurure, de certains oxydes tels que SiO₂, HfO₂, Ta₂O₅, TiO₂, GdOx, CuOx, WOx, ou de sulfures tels que GeSₓ, CuₓS ou AgS.

6. Cellule élémentaire (903, 903') **caractérisée en ce qu'**elle comporte un dispositif (905, 905', 905") selon l'une des revendications précédentes monté en série avec une cellule mémoire (904, 904') apte à présenter au moins deux états de résistivité correspondant à deux états mémoire.

7. Cellule élémentaire (903, 903') selon la revendication précédente **caractérisée en ce que** ladite cellule mémoire (904, 904') est une cellule mémoire non volatile réinscriptible telle qu'une mémoire OxRAM, CBRAM, MRAM, PCRAM, FeRAM ou STTRAM.

8. Cellule élémentaire (903') selon l'une des revendications 6 ou 7 **caractérisée en ce qu'**elle comporte deux dispositifs (905', 905") selon l'une des revendications 1 à 5 montés tête bêche en parallèle, l'ensemble desdits deux dispositifs en parallèle étant monté en série avec ladite cellule mémoire (904').

9. Matrice d'adressage (900) d'une pluralité de cellules élémentaires (903) **caractérisée en ce qu'**elle comporte :
- une pluralité de cellules élémentaires (903) selon l'une des revendications 6 à 8 ;
- deux niveaux de lignes de commande :
∘ un premier niveau incluant une pluralité de lignes de bits (901) parallèles entre elles ;
∘ un deuxième niveau incluant une pluralité de lignes de mots (902) parallèles entre elles ;
chacune desdites cellules (903) étant disposée au croisement d'une ligne de mots et d'une ligne de bits.

## Patentansprüche

1. Elektronische Vorrichtung (500, 500'), umfassend:
- eine erste Elektrode (502);
- eine zweite Elektrode (503);
- eine Feststoff-Elektrode (501) basierend auf ionischem, leitenden Material, wobei die genannte erste und zweite Elektrode jeweils auf jeder Seite des genannten Elektrolyts angeordnet sind, wobei das genannte erste und zweite Elektrolyt konfiguriert sind, um wenigstens ein metallisches Dendrit zwischen der genannten ersten Elektrode und der genannten zweiten Elektrode ausgehend von Metallionen zu bilden, die in dem genannten Elektrolyt zirkulieren, wenn eine Potenzialdifferenz, die höher als oder gleich einer ersten positiven Schwellenspannung (Vthon) zwischen der genannten ersten Elektrode (502) und der genannten zweiten Elektrode (503) angewendet ist;
wobei die genannte Vorrichtung zwei Widerstandszustände aufweist:
- einen hohen Widerstandszustand, bezeichnet als Zustand mit hohem Widerstand (OFF);
- einen niedrigen Widerstandszustand, bezeichnet als Zustand mit niedrigem Widerstand (ON);
wobei die genannte Vorrichtung (500) **dadurch gekennzeichnet ist, dass** die Konzentration des Metalls, das die Metallionen in dem genannten Elektrolyt bildet, derart ausgewählt ist, dass:
- die genannte Vorrichtung im Zustand mit hohem Widerstand verbleibt, solange die genannte erste Schwellenspannung (Vthon) zwischen der genannten ersten Elektrode (502) und der genannten zweiten Elektrode (503) nicht erreicht ist;
- die genannte Vorrichtung vom Zustand mit hohem Widerstand in den Zustand mit niedrigem Widerstand schaltet, wenn die genannte Potenzialdifferenz zwischen der genannten ersten Elektrode (502) und der genannten zweiten Elektrode (503) größer als oder gleich wie die genannte erste Schwellenspannung (Vthon) ist;
- die genannte Vorrichtung vom Zustand mit niedrigem Widerstand in den Zustand mit hohem Widerstand schaltet, wenn die Potenzialdifferenz zwischen der genannten ersten Elektrode (502) und der genannten zweiten Elektrode (503), die größer als oder gleich der genannten ersten Schwellenspannung ist, nicht mehr angewendet ist und beim Abnehmen eine zweite positive Schwellenspannung (Vthoff) erreicht, die strikt niedriger ist als die erste Schwellenspannung (Vthon).

2. Vorrichtung (500, 500') gemäß Anspruch 1, **dadurch gekennzeichnet, dass** die Metallkonzentration, die Metallionen in dem Elektrolyt bildet, niedriger ist als die Sättigungskonzentration des genannten Metalls in dem den Elektrolyt bildenden Material.

3. Vorrichtung (500') gemäß einem der voranstehenden Ansprühe, **dadurch gekennzeichnet, dass** er einen ionisierbaren Metallabschnitt (506) umfasst, der zwischen der genannten ersten Elektrode und dem genannten Elektrolyt zwischengeschaltet ist.

4. Vorrichtung (500, 500') gemäß einem der voranstehenden Ansprüche, **dadurch gekennzeichnet, dass** die genannten Metallionen, die in dem genannten Elektrolyt zirkulieren, Ag²⁺ -, ZN²⁺ oder CU²⁺ -Ionen sind.

5. Vorrichtung (500, 500') gemäß einem der voranstehenden Ansprüche, **dadurch gekennzeichnet, dass** das genannte Feststoff-Elektrolyt (501) ausgehend von einem Chalkogenid-Material, wie z. Z. einem Selenid oder einem Tellurid, bestimmten Oxiden, wie z. B. SiO₂, HfO₂, Ta₂O₅, TiO₂, GdOx, CuOx, WOx oder Sulfiden, wie z. B. GeSₓ, CuₓS oder AgS realisiert ist.

6. Schalteinheit (903, 903'), **dadurch gekennzeichnet, dass** sie eine Vorrichtung (905, 905', 905") gemäß einem der voranstehenden Ansprüche umfasst, die in Serie mit einer Speicherzelle (904, 904') montiert ist, die geeignet ist, wenigstens zwei Widerstandszustände aufzuweisen, die zwei Speicherzuständen entsprechen.

7. Schalteinheit (903, 903') gemäß dem voranstehenden Anspruch, **dadurch gekennzeichnet, dass** die genannte Speicherzelle (904, 904') eine wiederbeschreibbare, nicht flüchtige Speicherzelle, wie z. B. ein OxRAM-, CBRAM-, MRAM-, PCRAM-, FeRAM- oder STTRAM-Speicher ist.

8. Schalteinheit (903') gemäß einem der Ansprüche 6 oder 7, **dadurch gekennzeichnet, dass** sie zwei Vorrichtungen (905', 905") gemäß einem der Ansprüche 1 bis 5 umfasst, die kopfüber parallel montiert sind, wobei beide der genannten Vorrichtungen mit der genannten Speicherzelle (904') parallel in Serie montiert sind.

9. Adressierungsmatrix (900) einer Vielzahl von Schalteinheiten (903), **dadurch gekennzeichnet, dass** sie umfasst:
- eine Vielzahl von Schalteinheiten (903) gemäß einem der Ansprüche 6 bis 8;
- zwei Befehlszeilenebenen:
∘ eine erste Ebene, die eine Vielzahl von untereinander parallelen Bitzeilen (901) einschließt;
∘ eine zweite Ebene, die eine Vielzahl von untereinander parallelen Wortzeilen einschließt;
wobei jede der genannten Zeilen (903) an der Kreuzung einer Wortzeile und einer Bitzeile angeordnet ist.

## Claims

1. Electronic device (500, 500') comprising:
- a first electrode (502) ;
- a second electrode (503) ;
- a solid electrolyte (501) based on an ionic conductor material, said first and second electrodes being respectively arranged on either side of said electrolyte, said first and second electrodes being configured to form at least one metallic dendrite between said first electrode and said second electrode from metal ions circulating in said electrolyte when a potential difference greater than or equal to a first positive threshold voltage (Vthon) is applied between said first electrode (502) and said second electrode (503) ;
said device having two resistive states:
- a high resistance state, referred to as high resistive state (OFF) ;
- a low resistance state, referred to as low resistive state (ON) ;
- said device (500) being **characterised in that** the concentration of the metal forming the metal ions in said electrolyte is chosen in such a way that:
- said device remains at the high resistive state as long as said first threshold voltage (Vthon) between said first electrode (502) and said second electrode (503) is not reached;
- said device switches from the high resistive state to the low resistive state when the potential difference between said first electrode (502) and said second electrode (503) is greater than or equal to said first threshold voltage (Vthon) ;
- said device switches from the low resistive state to the high resistive state when the potential difference between said first electrode (502) and said second electrode (503) greater than or equal to said first threshold voltage is no longer applied and reaches by decreasing a second positive threshold voltage (Vthoff) strictly less than said first threshold voltage (Vthon).

2. Device (500, 500') according to claim 1 **characterised in that** the concentration of metal forming the metal ions in the electrolyte is less than the saturation concentration of said metal in the material forming the electrolyte.

3. Device (500') according to one of the preceding claims **characterised in that** it comprises a portion of ionisable metal (506) inserted between said first electrode and said electrolyte.

4. Device (500, 500') according to one of the preceding claims **characterised in that** said metal ions circulating in said electrolyte are Ag²⁺, Zn²⁺ or Cu²⁺ ions.

5. Device (500, 500') according to one of the preceding claims **characterised in that** said solid electrolyte (501) is carried out from a chalcogenide material such as a selenide or a telluride, certain oxides such as SiO₂, HfO₂, Ta₂O₅, TiO₂, GdOx, CuOx, WOx, or sulphides such as GeSₓ, CuₓS or AgS.

6. Elementary cell (903, 903') **characterised in that** it comprises a device (905, 905', 905") according to one of the preceding claims mounted in series with a memory cell (904, 904') able to have at least two resistive states corresponding to two memory states.

7. Elementary cell (903, 903') according to the preceding claim **characterised in that** said memory cell (904, 904') is a rewritable non-volatile memory cell such as an OxRAM, CBRAM, MRAM, PCRAM, FeRAM or STTRAM memory.

8. Elementary cell (903') according to one of claims 6 or 7 **characterised in that** it comprises two devices (905', 905") according to one of claims 1 to 5 mounted head-to-tail in parallel, with all of said two devices in parallel being mounted in series with said memory cell (904').

9. Matrix for addressing (900) a plurality of elementary cells (903) **characterised in that** it comprises:
- a plurality of elementary cells (903) according to one of claims 6 to 8 ;
- two levels of command lines:
∘ a first level including a plurality of bit lines (901) parallel to one another;
∘ a second level including a plurality of word lines (902) parallel to one another;
each one of said cells (903) being arranged at the crossing of a line of words and a line of bits.
